# NEW EUROPEAN PATENT SPECIFICATION

(11) **EP 3 894 826 B3**
(45) Date of publication of this specification: **12.06.2024**
(45) Mention of the grant of the patent: 24.01.2024
(21) Application number: 19845616.2
(22) Date of filing: 29.11.2019
(51) Int. Cl.: G01M 17/02, G01N 27/20, G01R 1/073, G01R 27/14, B60C 19/00

(54) **METHOD AND DEVICE FOR CHECKING THE ELECTRICAL CONDUCTIVITY OF TYRES FOR VEHICLE WHEELS**
VERFAHREN UND VORRICHTUNG ZUR PRÜFUNG DER ELEKTRISCHEN KONDUKTIVITÄT VON REIFEN FÜR FAHRZEUGRÄDER
PROCÉDÉ ET DISPOSITIF POUR TESTER LA CONDUCTIVITÉ ÉLECTRIQUE DES PNEUS POUR ROUES DE VÉHICULE

(30) Priority: 13.12.2018 IT 201800011054
(43) Date of publication of application: 20.10.2021
(73) Proprietor: Pirelli Tyre S.P.A., 20126 Milan (IT)
(72) Inventor: D'ORIA, Francesco, 20133 Milan (IT); HELD, Alessandro, 20126 Milano (IT); ROBERTI, Lorenzo, 20126 Milano (IT)
(74) Representative: PGA S.p.A.
(86) International application number: PCT/IB2019/060314
(87) International publication number: WO 2020/121107

(56) References cited:
- WO-A1-83/03681
- WO-A1-2018/099704
- WO-A1-2020/234959
- JP-A- 2015 157 632
- US-A1- 2015 241 491

## Description

### Technical field of the invention

The present invention relates to a method and a device for checking the electrical conductivity of tyres for vehicle wheels. The present invention falls within the field of processes and apparatuses for checking tyres for vehicle wheels.

A tyre for vehicle wheels generally comprises a carcass structure comprising at least one carcass ply having end flaps engaged with respective annular anchoring structures. A belt structure is associated in a radially outer position to the carcass structure, comprising one or more belt layers, arranged in radial superposition with respect to each other and with respect to the carcass ply, having textile or metallic reinforcing cords with crossed orientation and/or substantially parallel to the circumferential development direction of the tyre. A tread band is applied in a position radially outer to the belt structure, also made of elastomeric material like other semi-finished products making up the tyre. The assembly of at least said belt structure and said tread band form the crown structure of the tyre. Respective sidewalls of elastomeric material are further applied on the lateral surfaces of the carcass structure, each extending from one of the lateral edges of the tread band up at the respective annular anchoring structure to the beads. In "tubeless" tyres, the carcass ply is internally coated by a preferably butyl-based layer of elastomeric material, usually called "liner" having optimal airtight characteristics and extending from one to the other of the beads.

The production cycles of a tyre provide for a building process in which the various structural components of the tyre are made and/or assembled on one or more drums. The built green tyres are transferred to a moulding and vulcanisation line where a moulding and vulcanisation process is carried out to define the structure of the tyre according to a desired geometry and tread pattern.

### Definitions

"Tyre", when not otherwise specified, means both a green tyre and a moulded and vulcanised tyre
"Component" of a tyre means one or more parts of the tyre performing a function or a portion of each of them. For example, components are the liner, the carcass ply, the belt strip(s), the zero-degree layer, the conductive layer, the conductive insert, the tread band, the under-belt inserts, the sidewall inserts, the sidewalls, the bead cores, the filling element of the bead cores, the reinforcement inserts of elastomeric material alone or reinforced with cords, the carcass structure, the crown structure, etc.

The terms "radial" and "axial" and the expressions "radially inner/outer" and "axially inner/outer" are used referring to a direction perpendicular and a direction parallel to a tyre rotation axis, respectively.

The terms "circumferential" and "circumferentially" are instead used with reference to the annular development direction of the tyre.

By "rigid body" it is meant a body that in the elastic field does not deform in an evident manner when subjected to operating loads, or to the loads/pressures normally present when the body performs its function, or that does not adapt in the presence of said loads/pressures to the shape of a body external to it with which it comes into contact.

By "yielding body" it is meant a body that in the elastic field deforms noticeably when subjected to operating loads, i.e. to the loads/pressures normally present when the body performs its function, or that adapts in the presence of said loads/pressures to the shape of a body external to it with which it comes into contact.

The expressions "low", "below", "lower" or "inferiorly", and "high", "above", "upper" or "superiorly" are used to designate a relative mutual position of two elements or of one element with respect to the ground in normal operating condition.

### Prior art

Document EP1887367 illustrates a device provided with first electrodes resting against a plurality of portions of a radially outer surface of the tyre and with a second electrode placed in contact with an inner peripheral zone of the tyre itself for measuring an electrical resistance value between the tread and a bead of said tyre.

Document JP2017110958 discloses a radially outer electrode defined by a plate provided with a plurality of conductive portions in contact with a radially outer portion of the tyre and an inner electrode which is electrically connected to a radially inner portion of the tyre itself.

Document US20150241491 discloses a device for measuring the electrical resistance of a tyre provided with an outer electrode probe configured for resting against a portion of the tyre tread and an inner electrode configured for resting against a portion of a tyre bead. A predetermined measurement current is applied between the outer electrode and the inner electrode and a measuring instrument detects a voltage and measures the electrical resistance between the probes. Document KR101462429 discloses an apparatus for measuring the electrical resistance of a semi-finished product intended to define a tread band. The apparatus comprises an upper roller and a lower roller of conductive material arranged respectively on an upper side and on a lower side of the semi-finished product. A circuit for measuring the electrical resistance is connected to the upper roller and the lower roller.

Document WO 2018/099704 discloses a method for producing a tread band. The method comprises: extruding the tread band and an electrically conductive strip extending across the band from an outer side to an inner side thereof. The method provides for measuring an electrical resistance of the electrically conductive strip between the outer side and the inner side of the strip by an outer wheel and a support roller constituting respectively an outer electrode and an inner electrode. The method provides for emitting an alarm signal if the measured resistance is greater than a predefined maximum resistance.

Document EP1083425 discloses a method and a device for checking the components of a green tyre, such as a continuous extruded strip constituting a green tread band. The device comprises a control station arranged along a conveyor and comprising an upper terminal and a lower terminal electrically and respectively connectable to an upper surface and to a lower surface of the component. The terminals are rollers of conductive material.

### Summary

Modern tyres, even the best performing ones with a tread containing a high percentage of silica that gives them good handling but high electrical resistance, must allow discharging to earth the electrostatic charge due to the difference in potential between the vehicle and the ground, to avoid the generation of discharges that could cause serious damage, for example during refuelling, or even just to avoid annoying shocks to people who touch the vehicle.

In this context, the Applicant has felt the need to improve the technical solutions of the type illustrated in EP1887367, JP2017110958, US20150241491, KR101462429, WO2018/099704 and EP1083425.

The Applicant has observed that the surfaces of the tyres, green or vulcanised, and/or of the components destined to form the tyres, such as the tread band, against which one of the electrodes is applied to obtain the electrical resistance/conductivity, are not smooth and regular but usually have concavities and convexities such as to make the contact with the electrode uneven.

In particular, the Applicant has observed that the tyres not mounted on a rim or mounted but not inflated, green or vulcanised, may have an irregular and concave radially outer surface of the tread band, or having depressions in one or more zones, due to effect, for example, of the tension at which the reinforcement elements of the belt structure, such as metal and/or textile and/or hybrid threads, are subjected during building (according to the design specifications). Moreover, the tread band of vulcanised tyres has grooves and blocks.

The Applicant has also observed that the components intended to form tyres, such as continuous extruded strips described in KR101462429, WO2018/099704 and EP1083425, may have irregular surfaces also forming depressions.

The Applicant has therefore observed that the non-uniform contact of the electrode with the respective surface may distort the attainment of the electrical resistance, leading to discarding suitable tyres and/or semi-finished products or vice versa.

In particular, the Applicant has observed that if the tread band comprises an electrically conductive strip (conductive insert) which is generally positioned at a centre line of the tread band, it is possible that said strip is located in a more or less accentuated concavity and that, for this reason, the electrode does not touch it. In cases like this, the conductivity check results in a false negative.

The Applicant has therefore felt the need to be able to check the electrical conductivity of the tyres, more accurately so that the tyres deemed suitable after such check(s), once mounted on a vehicle, discharge static electricity when the vehicle is stationary and pass the tests required by the regulations.

The Applicant has also felt the need to identify a solution that can be used to check the electrical conductivity of green tyres and moulded and vulcanised tyres.

The Applicant has perceived that the necessary accuracy can be obtained by ensuring that the electrode or electrodes adhere(s) uniformly to the surface against which it/they rest(s), in order to reliably obtain the electrical resistance/conductivity, so as to accurately follow the depressions and without exerting excessive pressures that could damage the tyre itself.

Finally, the Applicant has found that this result can be obtained by making electrodes which, when deformed during use, follow the concavities/depressions of said surface.

According to a first aspect, the present invention relates to a device for checking the electrical conductivity of tyres for vehicle wheels, according to claims 1 or 8.

According to a second aspect, the present invention relates to a method for checking the electrical conductivity of tyres for vehicle wheels according to claim 11.

An apparatus for building tyres for vehicle wheels is also disclosed.

A process for building tyres for vehicle wheels is also disclosed.

The Applicant believes that the present invention allows accurately measuring the electrical resistance/conductivity of the built, green or vulcanised tyre.

In particular, the Applicant believes that the present invention allows obtaining a precise contact of the first electrode also in the depressions formed on the surface of the component whose electrical resistance is to be obtained, so as to provide accurate measurements which are not distorted by the irregularities of said surface. The Applicant believes that the present invention allows obtaining said precise contact even without exerting high pressures and such as to be able to damage the tyre and/or one or more of its components.

The present invention, in at least one of the above aspects thereof, can exhibit one or more of the following preferred features.

Preferably, the deformed engagement portion defines at least one electrically conductive contact portion.

Preferably, closing the electrical circuit with said component of said tyre comprises resting the second electrode against a different portion of the component or tyre.

Preferably, the contact portion is a protuberance configured for copying said at least one concavity of said surface.

Preferably, when said at least one contact portion copies at least in part said at least one concavity, said at least one contact portion is located in said at least one respective surface concavity.

Preferably, the first electrode copies the shape of the concavity when it is pressed against said surface and through the deformation of the engagement portion.

Preferably, the engagement portion has an undeformed configuration when the first electrode is spaced from said surface.

Preferably, the engagement portion has a plurality of deformed configurations according to a shape of the concavities of said surface.

Preferably, the elastically yielding and electrically conductive material has an electrical resistivity equal to or less than the electrical resistivity of steel.

Preferably, the elastically yielding and electrically conductive material has an electrical resistivity equal to or less than 10⁻¹ Ω*m at 20 °C, more preferably equal to or less than 10⁻⁶Ω*m at 20 °C.

Preferably, the elastically yielding and electrically conductive material is selected from the group comprising: electrically conductive silicone, electrically conductive expanded polymeric material, steel wool.

Preferably, the rigid body is more rigid than said at least one component.

Preferably, the rigid body is made of metal, more preferably of steel.

Preferably, the rigid body is a bar, more preferably having a circular section.

Preferably, the bar is configured for remaining stationary with respect to said surface.

Preferably, the engagement portion is arranged as a ring around the bar.

Preferably, the elastically yielding and electrically conductive material is arranged as a ring around the bar.

Preferably, the engagement portion comprises a helical spring comprising a plurality of coils and having a central axis configured for being arranged transversely to a longitudinal development of the component.

Preferably, the central axis of the helical spring is substantially parallel to a longitudinal axis of the bar.

Preferably, the helical spring is made of metal, more preferably of steel.

Preferably, the engagement portion comprises a plurality of springs projecting from the rigid body.

Preferably, the springs of said plurality develop substantially perpendicular to a longitudinal axis of the bar.

Preferably, the springs of said plurality are made of metal, more preferably of steel. Preferably, the engagement portion comprises a plurality of discs, more preferably of metal, mounted on terminal ends of the springs of said plurality of springs.

Preferably, the engagement portion comprises a plurality of balls or rollers, more preferably metallic, pushed away from the rigid body by said springs.

Preferably, the balls or rollers are pushed along directions perpendicular to a longitudinal axis of the bar.

Preferably, the springs of said plurality of springs, and more preferably the discs and/or balls and/or rollers, are part of a single electrical circuit of the first electrode connected to said meter.

Preferably, the elastically yielding and electrically conductive material is at least partly housed in said seat.

Preferably, the helical spring is at least partly housed in said seat.

Preferably, the springs of said plurality of springs are at least partly housed in said seat.

Preferably, the balls and/or rollers and/or discs are at least partly housed in said seat.

Preferably, the engagement portion, at least when it is in an undeformed configuration, protrudes from said seat.

Preferably, the discs and/or balls and/or rollers, at least when the springs of said plurality are in an undeformed configuration, protrude from said seat.

Preferably, the seat is defined by a milling made in the rigid body.

Preferably, said at least one seat is formed in a lateral wall of the bar.

Preferably, the engagement portion, at least when in an undeformed configuration, protrudes radially from the seat formed in the bar.

Preferably, a support frame is provided for a tyre.

Preferably, the support frame, more preferably electrically insulated, is configured for supporting the tyre lying on a sidewall thereof.

Preferably, a sidewall of the tyre rests on the frame.

Preferably, a voltage is generated and an electrical resistance is obtained while said first electrode and second electrode rest fixed against the tyre, i.e. do not move with respect to the tyre.

Preferably, the bar defining the rigid body is substantially parallel to a rotation axis of the tyre.

Preferably, the tread band comprises a conductive insert configured for surfacing on the radially outer surface of said tread band.

Preferably, the conductive insert has an electrical conductivity greater than an electrical conductivity of the tread band or an electrical resistance lower than an electrical resistance of the tread band.

Preferably, the conductive insert completely passes through a thickness of the tread band.

Preferably, the conductive insert is electrically in contact with the belt structure.

Preferably, the conductive insert extends over an entire circumferential extension of the tread band.

Preferably, the conductive insert is a continuous elongated element embedded in the tread band.

Preferably, the conductive insert is located at a centre line of the tread band.

Preferably, during the generation of the voltage and the attainment of the electrical resistance, the electrode exerts against the surface of the component a pressure greater than or equal to 0.5 bar.

Preferably, during the generation of the voltage and the attainment of the electrical resistance, the electrode exerts against the surface of said the component a pressure less than or equal to 6 bar.

This pressure is sufficient to obtain uniform contact between the first electrode and the surface of the component even inside the concavities without damaging the tyre.

Preferably, said at least one concavity comprises depressions of a radially outer surface of the tread band of a tyre caused for example by the tension at which reinforcement elements of the belt structure, such as metal and/or textile and/or hybrid cords, are subjected during building.

Preferably, said at least one concavity comprises grooves defining a tread pattern of the tread band of a vulcanised tyre.

Further features and advantages will become more apparent from the detailed description of preferred but non-exclusive embodiments of a method and a device for checking the electrical conductivity of tyres for vehicle wheels according to the present invention.

### Description of the drawings

Such description is given hereinafter with reference to the accompanying drawings, provided only for illustrative and, therefore, non-limiting purposes, in which:
- figure 1 illustrates a device for checking the electrical conductivity of tyres for vehicle wheels according to the present invention;
- figure 2 is an enlargement of the device of figure 1;
- figure 3 illustrates a variant of the device for checking the electrical conductivity of tyres for vehicle wheels not part of the present invention;
- figure 4 is an enlarged front view of the device of figure 3;
- figure 5 illustrates a further variant of the device for checking the electrical conductivity of tyres for vehicle wheels not part of the present invention;
- figure 6 is an enlarged front view of the device of figure 5;
- figure 7 illustrates an embodiment of an element of the device of figures 1 and 2;
- figure 8 is a view sectioned from above of the element of figure 7;
- figure 9 is a partially sectional view of a different embodiment of the element of figure 7;
- figure 10 is a partially sectional view of a further different embodiment of the element of figure 7;
- figure 11 illustrates a further different embodiment of the element of figure 7;
- figure 12 is a partial section of the element of figure 11;
- figure 13 is a radial half-section of a tyre for vehicle wheels.

### Detailed description

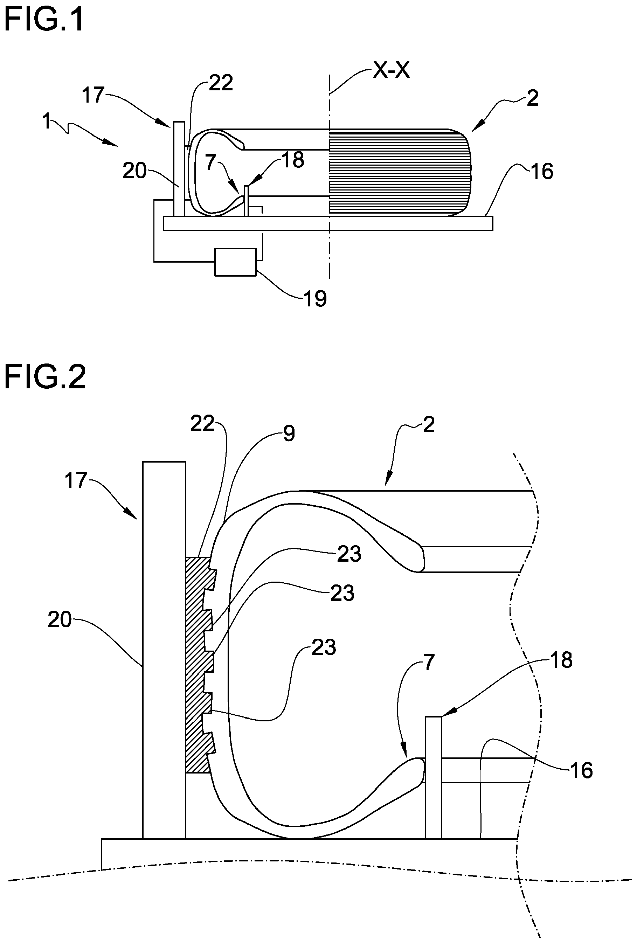

Figure 1 schematically illustrates a device for checking the electrical conductivity of tyres 2 for vehicle wheels according to the present invention.

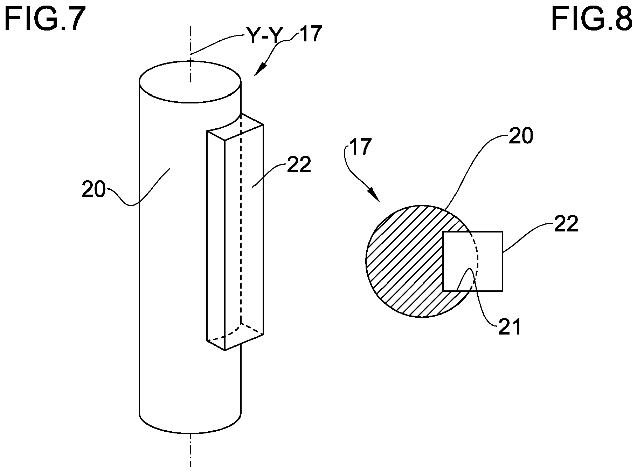

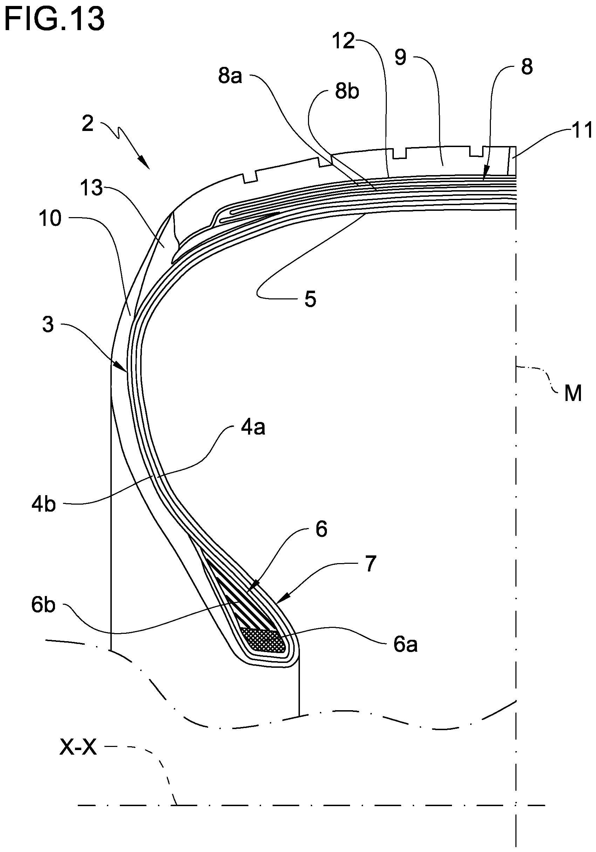

A tyre 2 is shown in figure 13 and essentially comprises a carcass structure 3 having one/two carcass plies 4a/4a, 4b. An airtight layer of elastomeric material or so-called liner 5 is applied internally to the carcass ply/plies 4a/4a, 4b. Two annular anchoring structures 6 comprising each a so-called bead core 6a bearing an elastomeric filler 6b in radially outer position are engaged to respective end flaps of the carcass ply or plies 4a/ 4a, 4b. The annular anchoring structures 6 are integrated in the proximity of zones usually identified by the name of "beads" 7, at which the engagement between tyre 2 and a respective mounting rim usually occurs. A belt structure 8 comprising for example belt layers 8a, 8b is circumferentially applied around the carcass ply/plies 4a/ 4a, 4b, and a tread band 9 is circumferentially overlapped to the belt structure 8. The belt structure 8 may be associated with so-called "under-belt inserts", not shown, placed each between the carcass ply/plies 4a/4a, 4b and one of the axially opposite end edges of the belt structure 8. Two sidewalls 10, extending each from the respective bead 7 to a corresponding lateral edge of the tread band 9, are applied in laterally opposite positions on the carcass ply/plies 4a/4a, 4b. The portion of each sidewall 10 close to the side edge of the tread band 9 is known as the tyre shoulder. Tyre 2 has an axial plane of symmetry "M" (figure 7) equidistant from the respective beads 7 and perpendicular to its axis of rotation "X-X", when tyre 2 is in service.

In the illustrated embodiment, the tyre 2 further comprises a conductive insert 11 and a conductive layer 12. The conductive layer 12 is located in a position radially inner to the tread band 9 and in a position radially outer to the belt layers 8a, 8b. The conductive insert 11 surfaces on a radially outer surface of the tread band 9, passes through the thickness of said tread band 9 and is in contact with the conductive layer 12. The conductive insert 11 is a continuous elongated element embedded in the tread band 9 and extends by a whole circumferential extension of the tread band 9. The conductive insert 11, in the example shown herein, is located at a centre line of the tread band 9.

The conductive layer 12 extends to axially opposed end portions 13 of the tread band 9 forming part of the sidewalls 10 and preferably made of the same material as said conductive insert 11 and conductive layer 12. The conductive insert 11 may be defined by a protuberance of the conductive layer 12.

The tread 9 is formed for example of non-conductive elastomeric material which has, after vulcanisation, an electrical resistivity greater than or equal to 10⁴Ω*m at room temperature. The conductive insert 11 and the conductive layer 12 are formed for example by a conductive elastomeric material which, after vulcanisation at room temperature, has an electrical resistivity of less than or equal to 3*10³Ω*m. The conductive insert 11 has an electrical conductivity greater than an electrical conductivity of the tread band 9 or an electrical resistance lower than an electrical resistance of the tread band 9.

The conductive insert 11, when the tyre 2 is mounted on a rim to form a wheel and the wheel is mounted on a vehicle, is in contact with the ground and allows discharging the static electricity of the vehicle to the ground through the rim, the bead(s) 7 and other conductive elements of the tyre 2 which electrically connect the bead(s) 7 to the conductive insert 11.

For example, the conductive insert 11, the conductive layer 12 and the end portions 13 define a conductive circuit which is electrically connected to the carcass plies 4a, 4b and thus to the beads 7. Alternatively, if the belt structure 8 is conductive, the conductive layer 12 may not be present and the conductive insert 11 is directly connected to said belt structure 8.

The device 1 for checking the electrical conductivity illustrated in figures 1 and 2 is configured for performing said check on a built tyre 2, in the green or vulcanised state.

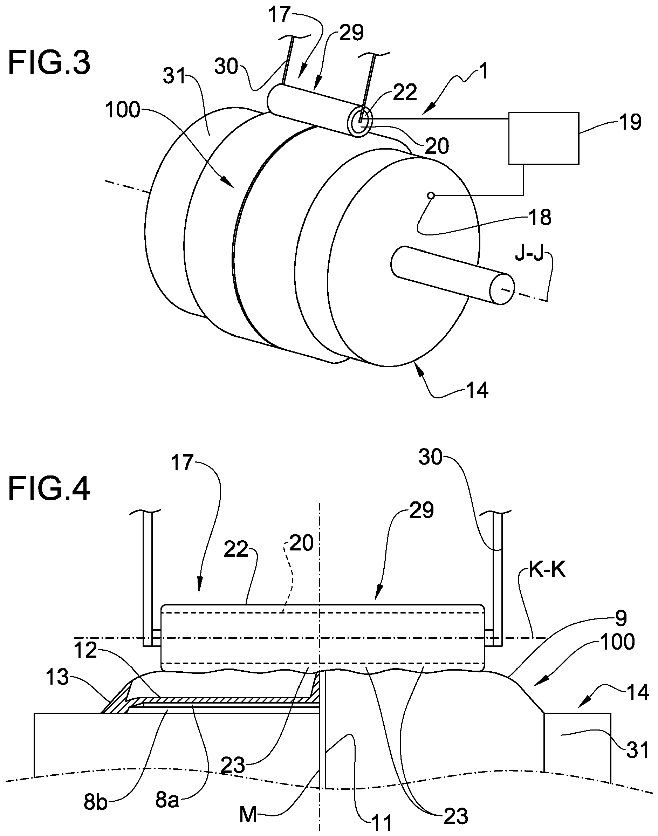

The device 1 for checking the electrical conductivity illustrated in figures 3 and 4 is not part of the present invention and is configured for performing said check on a tyre being processed 100 or comprising at least one component of the tyre wound on a building drum 14.

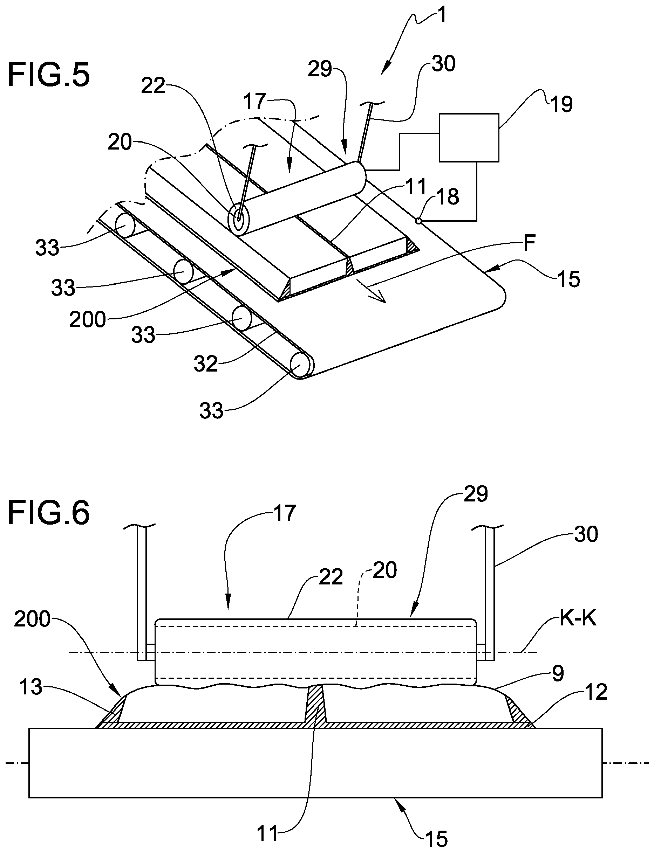

The device 1 for checking the electrical conductivity shown in figures 5 and 6 is not part of the present invention and is configured for performing said check on an elastomeric strip 200 laid flat and transported on a conveyor 15 along a transport direction "F".

The device 1 of figures 1 and 2 comprises a support frame 16, preferably made of insulating material, configured for receiving and supporting a tyre 2 resting on a sidewall thereof. The device 1 comprises a first electrode 17 arranged in a position radially outer to the tyre 2 resting on the support frame 16. The first electrode 17 is configured for resting against a tread band 9 of the tyre 2 intended to rest on the ground when the tyre 2 is mounted on a vehicle. The device 1 comprises a second electrode 18 arranged in a position radially inner to the tyre 2 and configured for resting against a bead 7 of the tyre 2. The first electrode 17 and the second electrode 18 are electrically connected to a meter 19, for example to an insulation tester. The meter 19 is configured for generating a voltage between the first electrode 17 and the second electrode 18, measuring an electric current between said first electrode 17 and said second electrode 18, finally obtaining an electrical resistance between said first electrode 17 and said second electrode 18.

In the embodiment of figures 1 and 2, the second electrode 18 is a metal pin which rests against the bead 7 of the tyre 2 closest to the support frame 16. The second electrode 18 is configured for closing an electric circuit with the tyre 2.

The first electrode 17 comprises a rigid body 20 defined by a steel bar with a circular section which, when the tyre 2 rests on the support frame 16, extends parallel to the rotation axis "X-X" of the tyre 2. As better illustrated in figures 7 and 8, the bar has a seat 21 defined by a milling obtained in a side wall thereof and having an elongated shape along a longitudinal extension of the bar itself (figure 8).

An elastically yielding engagement portion 22 defined by an elastically yielding and electrically conductive material is partly housed in the seat 21 and partly protrudes radially from the seat 21. The engagement portion 22 is a sort of substantially parallelepiped pad partially housed in the seat 21.

In embodiments not shown, the bar is coated with the elastically yielding and electrically conductive material which forms a ring or a hollow cylinder around the bar itself.

The elastically yielding and electrically conductive material has an electrical resistivity equal to or less than the electrical resistivity of steel. Preferably, the elastically yielding and electrically conductive material has at 20 °C an electrical resistivity equal to or less than 10⁻¹Ω*m, more preferably equal to or less than 10⁻⁶Ω*m. The elastically yielding and electrically conductive material is for example electrically conductive silicone, electrically conductive expanded polymeric material or steel wool.

A radially outer surface of the tread band 9 of the tyre 2 (in particular if not mounted on a rim or mounted without inflating) has concavities/depressions and convexities due to, for example, the tension to which the reinforcement elements of the belt are subjected during building (figure 2). Moreover, if the tyre 2 is vulcanised, such a radially outer surface has grooves and blocks defining a tread pattern (figures 2 and 13).

In use the first electrode 17 is brought into contact with the tread band 9, resting the elastically yielding engagement portion 22 thereon and pressing it against the tread band 9 with a pressure preferably of between 0.5 bar and 6 bar.

Since the engagement portion 22 is more flexible than the tread band 9, said engagement portion 22 deforms elastically and defines electrically conductive contact portions 23 which copy the irregularities of the radially outer surface of said tread band 9 (i.e., the concavities/depressions and convexities due to the tension to which the reinforcement elements of the belt structure and/or the tread pattern are subjected during building). In particular, the contact portions 23 are protuberances which copy the concavities defined in the radially outer surface of the tread band 9, are located in said concavities and touch a bottom of said concavities. Therefore, the engagement portion 22 has a plurality of deformed configurations which are a function of a shape of said radially outer surface of said tread band 9. The engagement portion 22 again assumes its own undeformed shape when the first electrode 17 is again moved away from the radially outer surface of the tread band 9.

While the first electrode 17 and the second electrode 18 are fixed against the tyre 2, that is they do not move with respect to the tyre 2, it is provided to generate the voltage and obtain the electrical resistance through the meter 19.

For example, the applied voltage may be fixed or variable and between 0V and 5000V with an electrical power between 0W and 5W. The meter 19 or an electronic control unit connected to the meter 19 allows obtaining a curve of the electrical resistance/conductivity in the measurement time and/or a value of the electrical resistance/conductivity. From the above measurement, a curve of the electrical resistance is obtained in the measurement time. This curve of the electrical resistance obtained is, for example, compared with a reference curve of the electric resistance. According to a possible evaluation criterion, if the obtained curve is below the reference curve for the whole measurement time selected, then the electrical conductivity is acceptable. Instead of comparing the above curves in their entirety, it is possible to obtain and compare a single obtained value of the resistance with a single reference value of the resistance. For example, the obtained and reference values are the peak values of the respective curves. Alternatively, the obtained and reference values are substantially constant asymptotic values that the curves assume after an initial transient. For example, the reference value of peak electrical resistance below which the conductivity is acceptable for a vulcanised tyre may be 100 MΩ, or for different specific needs it may be 10 GΩ. If the curve and/or the electrical resistance obtained value is/are not acceptable, the meter 19 emits a notification and/or alarm signal.

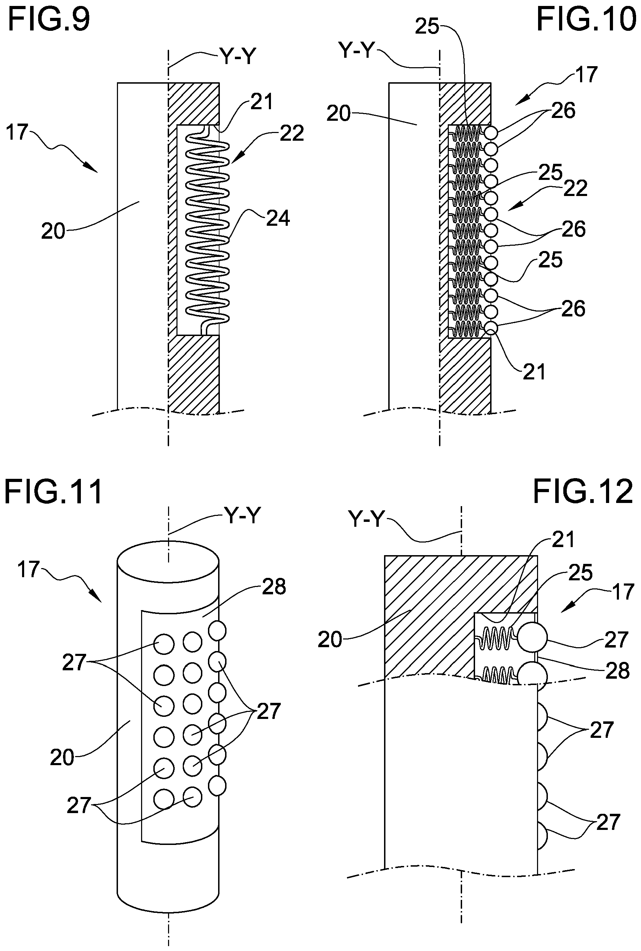

In the embodiment of figure 9, the engagement portion 22 comprises, instead of the parallelepiped pad in the elastically yielding and electrically conductive material, a helical steel spring 24 comprising a plurality of coils and having a central axis substantially parallel to a longitudinal axis "Y-Y" of the bar. Opposite ends of the helical spring 24 are fixed to opposite walls of the seat 21 and said helical spring 24 is partially inserted in the seat 21. The coils of the helical spring 24 project beyond the seat 21, at least when the helical spring 24 is not stressed/deformed, so as to move and deform along a radial direction with respect to the longitudinal axis "Y-Y" of the bar when the helical spring 24 is resting against the tread band 9. Also in this embodiment, the engagement portion 22 defined by the helical spring 24 is more yielding than the tread band 9 and deforms elastically defining the electrically conductive contact portions 23 which copy the irregularities of the radially outer surface of the tread band 9.

In the embodiment of figure 10, the engagement portion 22 comprises a plurality of steel springs 25 which project from the rigid body 20. In particular, each of the springs 25 is fixed to a bottom wall of the seat 21 and is cantilevered from said bottom wall along a radial direction with respect to a longitudinal axis "Y-Y" of the bar. Terminal ends of the springs 25 project beyond the seat 21 and carry metal discs 26. When the discs 26 of the first electrode 17 are resting against the tread band 9, the springs 25 deform elastically by copying the irregularities of the radially outer surface of the tread band 9.

In the embodiment of figures 11 and 12, the engagement portion 22 comprises a plurality of steel balls 27 which partially protrude from holes made in a lateral wall 28 of the bar. The lateral wall 28 closes the seat 21 and between each ball 27 and a bottom wall of the seat 21, a spring 25 is interposed which pushes the respective ball 27 radially outward. The balls 27 are held by the edges of the respective holes and when the balls 27 rest against the tread band 9, the springs 25 deform elastically and the balls 27 partially or totally retract, copying the irregularities of the radially outer surface of the tread band 9. In a variant not shown, instead of the balls 27 there may be present rollers.

The coils of the helical spring 24 of figure 9 (and thus the springs 25 and the discs 26 of figure 12 and also the springs 25 and the balls 27 of figures 11 and 12) are in electrical contact with each other and in electrical contact with the respective bar, to form a single electrical circuit of the first electrode 17 connected to the meter 19. In this way, whatever the coil or spring 25 or disc 26 or ball 27 coming into contact with a conductive portion of the tread band 9, like the conductive insert 11, the electric circuit with the second electrode 18 is closed.

The first electrode 17 of the device 1 for checking the electrical conductivity illustrated in figures 3 and 4 (configured for performing said check on the tyre being processed 100 wound on the building drum 14) comprises a roller 29 rotatably supported by a respective frame 30, illustrated only partially, and free to rotate around a respective rotation axis "K-K".

The building drum 14 is part of an apparatus for building tyres for vehicle wheels. The building drum 14 has a radially outer surface 31 configured for receiving components of the tyre being processed 100. The radially outer surface 31 is made of electrically conductive material, for example steel.

A motor, not shown and connected or connectable to the building drum 14, is configured for rotating the building drum 14 around a central axis "J-J" thereof. The apparatus for building tyres comprises at least one deposition device, not shown, located in the proximity of the radially outer surface of the building drum 14 and configured for winding at least one of the components of the tyre being processed 100 around the radially outer surface 31 while the motor rotates the building drum 14, according to a process for building tyres for vehicle wheels.

In the embodiment illustrated in figures 3 and 4, which is not part of the present invention, the tyre being processed 100 comprises a crown structure already completely deposited on the building drum 14. As shown in figure 4, the crown structure comprises two belt layers 8a, 8b, the conductive layer 12 arranged in a radially outer position to the two belt layers 8a, 8b and the tread band 9 with the end portions 13 and the conductive insert 11 arranged radially outer to the conductive layer 12. Axially opposite ends of the conductive layer 12 and the end portions 13 touch the radially outer surface 31 of the building drum 14.

The roller 29 is located in a position radially outer to the radially outer surface 31 of the building drum 14 and faces said radially outer surface 31.

The rigid body 20 is, in this embodiment, defined by a central portion of the roller 29 and the elastically yielding engagement portion 22 is defined by the aforementioned elastically yielding and electrically conductive material wound around the rigid body 20.

The meter 19 is connected to the roller 29 and is also connected to the building drum 14, for example by means of sliding contacts. The building drum 14 and in particular the radially outer surface 31 of the building drum 14 is therefore electrically in contact with the second electrode 18 or performs the function of a second electrode.

The roller 29 rests against the radially outer surface of the tread band 9 with its rotation axis "K-K" parallel to the central axis "J-J" and is pressed against the tread band 9 with a pressure preferably between 0.5 bar and 6 bar, for example between 2 bar and 3 bar. The roller 29 rolls on said surface driven in rotation by the building drum 14 which is rotated by the motor, not shown.

The elastically yielding and electrically conductive material forming the peripheral circumferential portion of the roller 29 is more flexible than the tread band 9, elastically deforms and defines the electrically conductive contact portions 23 which follow the concavities of the radially outer surface of said tread band 9. The elastically yielding and electrically conductive material therefore touches the conductive insert 11 even if this is located in a concavity of the aforementioned radially outer surface (figure 4).

While the roller 29 rolls on the radially outer surface, it is provided to generate the voltage and obtain the electrical resistance through the meter 19.

Alternatively, the attainment of the electrical resistance of the tyre being processed 100 can be achieved in static conditions by carrying out the measurements on several portions (preferably at least 3) of the radially outer surface of said tyre being processed 100, each time rotating the building drum 14 by means of the aforementioned motor.

The first electrode 17 of the device 1 for checking the electrical conductivity illustrated in figures 5 and 6 (configured for performing said check on the elastomeric strip 200 laid flat and transported on the conveyor 15) also comprises a roller 29 similar to the one just described above (and for which the same reference numerals are used).

The elastomeric strip 200 illustrated in figures 5 and 6 and transported by the conveyor 15 is a tread band 9 comprising the conductive layer 12, the end portions 13 and the conductive insert 11. The conveyor 15 comprises for example a conveyor belt 32 wound on motorised rollers 33 and the elastomeric strip 200, in particular the conductive layer 12, rests on an upper branch of the conveyor belt 32. Alternatively, the conveyor 15 comprises a series of motorised rollers arranged in sequence and close together, without any conveyor belt, and the elastomeric strip 200 rests directly on these motorised rollers.

The roller 29 is located above the conveyor 15 and faces an upper surface of the tread band 9, so that it can be rested against the aforementioned upper surface. The second electrode 18 is electrically connected to the upper branch of the conveyor belt 32 or, if the conveyor belt 32 is not present, to one of the vertically motorised rollers aligned with the roller 29.

The roller 29 rests against the upper surface of the tread band 9 with its rotation axis "K-K" perpendicular to the transport direction "F" and is pressed against the tread band 9 with a pressure preferably between 0.5 bar and 6 bar, for example between 2 bar and 3 bar. The roller 29 rolls on said surface driven in rotation by the conveyor 15.

The elastically yielding and electrically conductive material forming the peripheral circumferential portion of the roller 29 is more flexible than the tread band 9, elastically deforms and defines the electrically conductive contact portions 23 which follow the concavities of the upper surface of said tread band 9 (figure 6).

While the roller 29 rolls on the upper surface, it is provided to generate the voltage and obtain the electrical resistance through the meter 19.

As illustrated in the exemplary embodiments of figures 3, 4 and 5, 6, the roller 29 has an axial width substantially equal to a width of the tread band 9, but in any case less than the width between the end portions 13 to avoid an electricity flow that would distort the measurement of electrical conductivity. In embodiments not shown, this axial width of the roller 29 may be different, for example less than the width of the tread band 9. For example, the roller 29 is sized as a wheel resting on the tread band 9 only at the conductive insert 11 and has an axial width substantially equal to that of the conductive insert 11.

## Claims

1. Device for checking the electrical conductivity of tyres for vehicle wheels, comprising:
a support frame (16) for a tyre (2);
at least a first electrode (17) configured for resting against a surface of a component of the tyre (2); wherein said at least one first electrode (17) is arranged radially outside the tyre (2) and is configured for resting against a tread band (9) of the tyre (2);
at least a second electrode (18) configured for closing an electric circuit with said component of said tyre (2); wherein said at least one second electrode (18) is arranged radially inside the tyre (2) and is configured for resting against at least one bead (7) of the tyre (2);
at least one meter (19) operatively connected to the first electrode (17) and to the second electrode (18), wherein the meter (19) is configured for generating a voltage between the first electrode (17) and the second electrode (18) and obtaining an electrical resistance between said first electrode (17) and said second electrode (18);
wherein the first electrode (17) comprises a rigid body (20) and an engagement portion (22) more yielding than the component, so as to deform when the first electrode (17) is placed against the surface of the component and at least partially copy at least one concavity of said surface of the component;
wherein the engagement portion (22) comprises an elastically yielding and electrically conductive material;
**characterized in that** the rigid body (20) has at least one seat (21) and wherein the engagement portion (22) is at least partly housed in said seat (21).

2. Device as claimed in claim 1, wherein the elastically yielding and electrically conductive material is selected from the group comprising: electrically conductive silicone, electrically conductive expanded polymeric material, steel wool.

3. Device as claimed in claim 1, wherein the engagement portion (22) comprises a helical spring (24) comprising a plurality of coils and having a central axis (Y-Y) configured for being arranged transversely to a longitudinal development of the component.

4. Device as claimed in claim 1, wherein the engagement portion (22) comprises a plurality of springs (25) projecting from the rigid body (20).

5. Device as claimed in claim 1, wherein the engagement portion (22), at least when it is in an undeformed configuration, protrudes from said seat (21).

6. Device as claimed in claim 1 or 5, wherein the seat (21) is defined by a milling made in the rigid body (20).

7. Device as claimed in any one of claims 1 to 6, wherein the rigid body (20) is a bar.

8. Device for checking the electrical conductivity of tyres for vehicle wheels, comprising:
a support frame (16) for a tyre (2); at least a first electrode (17) configured for resting against a surface of a component of the tyre (2); wherein said at least one first electrode (17) is arranged radially outside the tyre (2) and is configured for resting against a tread band (9) of the tyre (2); at least a second electrode (18) configured for closing an electric circuit with said component of said tyre (2); wherein said at least one second electrode (18) is arranged radially inside the tyre (2) and is configured for resting against at least one bead (7) of the tyre (2); at least one meter (19) operatively connected to the first electrode (17) and to the second electrode (18), wherein the meter (19) is configured for generating a voltage between the first electrode (17) and the second electrode (18) and obtaining an electrical resistance between said first electrode (17) and said second electrode (18); wherein the first electrode (17) comprises a rigid body (20) and an engagement portion (22) more yielding than the component, so as to deform when the first electrode (17) is placed against the surface of the component and at least partially copy at least one concavity of said surface of the component; wherein the engagement portion (22) comprises an elastically yielding and electrically conductive material; **characterized in that** the elastically yielding and electrically conductive material externally covers the rigid body (20).

9. Device as claimed in claim 8, wherein the elastically yielding and electrically conductive material is selected from the group comprising: electrically conductive silicone, electrically conductive expanded polymeric material, steel wool.

10. Device as claimed in any one of claims 8 to 9, wherein the rigid body (20) is a bar.

11. Method for checking the electrical conductivity of tyres for vehicle wheels, comprising:
arranging a tyre (2) on a support frame (16);
resting at least a first electrode (17) against a surface of a component of the tyre (2); wherein the first electrode (17) is resting against a tread band (9) of the tyre (2);
resting at least a second electrode (18) against a different portion of the component or of the tyre (2); wherein the second electrode (18) is resting against at least one bead (7) of the tyre (2);
generating a voltage between the first electrode (17) and the second electrode (18) and obtaining an electrical resistance between said first electrode (17) and second electrode (18);
wherein resting the first electrode (17) comprises resting an engagement portion (22) of the first electrode (17) against the surface of the component,
wherein said engagement portion (22) is more yielding than the component so as to deform when the first electrode (17) is rested against said surface of the component;
the deformed engagement portion (22) defining at least one electrically conductive contact portion (23) copying at least in part at least one concavity of said surface of the component;
wherein the engagement portion (22) comprises an elastically yielding and electrically conductive material;
**characterized in that** the elastically yielding and electrically conductive material externally covers a rigid body (20) or **in that** the rigid body (20) has at least one seat (21) and wherein the engagement portion (22) is at least partly housed in said seat (21); wherein the engagement portion (22) is elastically yielding and takes back its own undeformed shape when the first electrode (17) is moved away from the component.

12. Method as claimed in claim 11, wherein said at least one concavity comprises depressions of a radially outer surface of the tread band.

13. Method as claimed in claim 11, wherein, if the tyre is vulcanised, said at least one concavity comprises grooves defining a tread pattern of the tread band.

## Patentansprüche

1. Vorrichtung zum Prüfen der elektrischen Leitfähigkeit von Reifen für Fahrzeugräder, umfassend:
einen Tragrahmen (16) für einen Reifen (2);
mindestens eine erste Elektrode (17), die dazu ausgelegt ist, an einer Oberfläche einer Komponente des Reifens (2) anzuliegen; wobei die mindestens eine erste Elektrode (17) radial außerhalb des Reifens (2) angeordnet und dazu ausgelegt ist, an einem Laufflächenband (9) des Reifens (2) anzuliegen;
mindestens eine zweite Elektrode (18), die zum Schließen einer elektrischen Schaltung mit der Komponente des Reifens (2) ausgelegt ist; wobei die mindestens eine zweite Elektrode (18) radial innerhalb des Reifens (2) angeordnet und dazu ausgelegt ist, an mindestens einem Wulst (7) des Reifens (2) anzuliegen;
mindestens ein Messgerät (19), das funktionell mit der ersten Elektrode (17) und mit der zweiten Elektrode (18) verbunden ist, wobei das Messgerät (19) zum Erzeugen einer Spannung zwischen der ersten Elektrode (17) und der zweiten Elektrode (18) und Erhalten eines elektrischen Widerstands zwischen der ersten Elektrode (17) und der zweiten Elektrode (18) ausgelegt ist;
wobei die erste Elektrode (17) einen starren Körper (20) und einen Eingriffsabschnitt (22) umfasst, der mehr nachgibt als die Komponente, sodass er sich verformt, wenn die erste Elektrode (17) an der Oberfläche der Komponente platziert wird, und mindestens eine Konkavität der Oberfläche der Komponente zumindest teilweise kopiert;
wobei der Eingriffsabschnitt (22) ein elastisch nachgiebiges und elektrisch leitendes Material umfasst;
**dadurch gekennzeichnet, dass** der starre Körper (20) mindestens einen Sitz (21) aufweist, und wobei der Eingriffsabschnitt (22) zumindest teilweise in dem Sitz (21) aufgenommen ist.

2. Vorrichtung nach Anspruch 1, wobei das elastisch nachgiebige und elektrisch leitende Material aus der Gruppe ausgewählt ist, die umfasst: elektrisch leitendes Silikon, elektrisch leitendes expandiertes Polymermaterial, Stahlwolle.

3. Vorrichtung nach Anspruch 1, wobei der Eingriffsabschnitt (22) eine Schraubenfeder (24) umfasst, die eine Mehrzahl von Spulen umfasst und eine Mittelachse (Y-Y) aufweist, die dazu ausgelegt ist, quer zu einer Längsausrichtung der Komponente angeordnet zu werden.

4. Vorrichtung nach Anspruch 1, wobei der Eingriffsabschnitt (22) eine Mehrzahl von Federn (25) umfasst, die vom starren Körper (20) vorsteht.

5. Vorrichtung nach Anspruch 1, wobei der Eingriffsabschnitt (22) wenigstens dann vom Sitz (21) vorsteht, wenn er in einer unverformten Konfiguration ist.

6. Vorrichtung nach Anspruch 1 oder 5, wobei der Sitz (21) durch Fräsen definiert ist, das im starren Körper (20) durchgeführt wird.

7. Vorrichtung nach einem der Ansprüche 1 bis 6, wobei der starre Körper (20) ein Stab ist.

8. Vorrichtung zum Prüfen der elektrischen Leitfähigkeit eines Reifens für Fahrzeugräder, umfassend: einen Tragrahmen (16) für einen Reifen (2); mindestens eine erste Elektrode (17), die dazu ausgelegt ist, an einer Oberfläche einer Komponente des Reifens (2) anzuliegen;
wobei die mindestens eine erste Elektrode (17) radial außerhalb des Reifens (2) angeordnet und dazu ausgelegt ist, an einem Laufflächenband (9) des Reifens (2) anzuliegen; mindestens eine zweite Elektrode (18), die zum Schließen einer elektrischen Schaltung mit der Komponente des Reifens (2) ausgelegt ist;
wobei die mindestens eine zweite Elektrode (18) radial innerhalb des Reifens (2) angeordnet und dazu ausgelegt ist, an mindestens einem Wulst (7) des Reifens (2) anzuliegen;
mindestens ein Messgerät (19), das funktionell mit der ersten Elektrode (17) und der zweiten Elektrode (18) verbunden ist, wobei das Messgerät (19) zum Erzeugen einer Spannung zwischen der ersten Elektrode (17) und der zweiten Elektrode (18) und Erhalten eines elektrischen Widerstands zwischen der ersten Elektrode (17) und der zweiten Elektrode (18) ausgelegt ist;
wobei die erste Elektrode (17) einen starren Körper (20) und einen Eingriffsabschnitt (22) umfasst, der mehr nachgibt als die Komponente, sodass er sich verformt, wenn die erste Elektrode (17) an der Oberfläche der Komponente platziert wird, und mindestens eine Konkavität der Oberfläche der Komponente zumindest teilweise kopiert;
wobei der Eingriffsabschnitt (22) ein elastisch nachgiebiges und elektrisch leitendes Material umfasst; **dadurch gekennzeichnet, dass** das elastisch nachgiebige und elektrisch leitende Material den starren Körper (20) extern abdeckt.

9. Vorrichtung nach Anspruch 8, wobei das elastisch nachgiebige und elektrisch leitende Material aus der Gruppe ausgewählt ist, die umfasst: elektrisch leitendes Silikon, elektrisch leitendes, expandiertes Polymermaterial, Stahlwolle.

10. Vorrichtung nach einem der Ansprüche 8 bis 9, wobei der starre Körper (20) ein Stab ist.

11. Verfahren zur Prüfung der elektrischen Leitfähigkeit von Reifen für Fahrzeugräder, umfassend:
Anordnen eines Reifens (2) auf einem Tragrahmen (16);
Anlegen mindestens einer ersten Elektrode (17) an eine Oberfläche einer Komponente des Reifens (2);
wobei die erste Elektrode (17) an einem Laufflächenband (9) des Reifens (2) anliegt;
Anlegen mindestens einer zweiten Elektrode (18) an einen anderen Abschnitt der Komponente oder des Reifens (2);
wobei die zweite Elektrode (18) an einem Wulst (7) des Reifens (2) anliegt;
Erzeugen einer Spannung zwischen der ersten Elektrode (17) und der zweiten Elektrode (18) und Erhalten eines elektrischen Widerstands zwischen der ersten Elektrode (17) und der zweiten Elektrode (18);
wobei das Anlegen der ersten Elektrode (17) ein Anlegen eines Eingriffsabschnitts (22) der ersten Elektrode (17) an die Oberfläche der Komponente umfasst,
wobei der Eingriffsabschnitt (22) nachgiebiger als die Komponente ist, sodass er sich verformt, wenn die erste Elektrode (17) an die Oberfläche der Komponente angelegt wird;
der verformte Eingriffsabschnitt (22) mindestens einen elektrisch leitenden Kontaktabschnitt (23) definiert, der mindestens eine Konkavität der Oberfläche der Komponente zumindest teilweise kopiert;
wobei der Eingriffsabschnitt (22) ein elastisch nachgiebiges und elektrisch leitendes Material umfasst;
**dadurch gekennzeichnet, dass** das elastisch nachgiebige und elektrisch leitende Material einen starren Körper (20) extern abdeckt, oder dadurch, dass der starre Körper (20) mindestens einen Sitz (21) aufweist, und wobei der Eingriffsabschnitt (22) zumindest teilweise in dem Sitz (21) aufgenommen wird; wobei der Eingriffsabschnitt (22) elastisch nachgiebig ist und seine eigene unverformte Form wieder annimmt, wenn die erste Elektrode (17) von der Komponente wegbewegt wird.

12. Verfahren nach Anspruch 11, wobei die mindestens eine Konkavität Vertiefungen einer radial äußeren Oberfläche des Laufflächenbandes umfasst.

13. Verfahren nach Anspruch 11, wobei der Reifen vulkanisiert wird, wobei die mindestens eine Konkavität Rillen umfasst, die ein Laufflächenmuster des Laufflächenbandes definieren.

## Revendications

1. Dispositif de contrôle de la conductivité électrique de pneus pour roues de véhicule, comprenant :
un cadre de support (16) pour un pneu (2) ;
au moins une première électrode (17) configurée pour s'appuyer contre une surface d'un composant du pneu (2) ; dans lequel ladite au moins une première électrode (17) est agencée radialement à l'extérieur du pneu (2) et est configurée pour s'appuyer contre une bande de roulement (9) du pneu (2) ;
au moins une seconde électrode (18) configurée pour fermer un circuit électrique avec ledit composant dudit pneu (2) ; dans lequel ladite au moins une seconde électrode (18) est agencée radialement à l'intérieur du pneu (2) et est configurée pour s'appuyer contre au moins un talon (7) du pneu (2) ;
au moins un compteur (19) connecté fonctionnellement à la première électrode (17) et à la seconde électrode (18), dans lequel le compteur (19) est configuré pour générer une tension entre la première électrode (17) et la seconde électrode (18) et obtenir une résistance électrique entre ladite première électrode (17) et ladite seconde électrode (18) ;
dans lequel la première électrode (17) comprend un corps rigide (20) et une partie d'engagement (22) plus souple que le composant, de manière à se déformer lorsque la première électrode (17) est placée contre la surface du composant et au moins partiellement copier au moins une concavité de ladite surface du composant ;
dans lequel la partie d'engagement (22) comprend un matériau élastiquement souple et électriquement conducteur ;
**caractérisé en ce que** le corps rigide (20) a au moins un siège (21) et dans lequel la partie d'engagement (22) est au moins partiellement logée dans ledit siège (21).

2. Dispositif tel que revendiqué dans la revendication 1, dans lequel le matériau élastiquement souple et électriquement conducteur est choisi dans le groupe comprenant : le silicone électriquement conducteur, un matériau polymère expansé électriquement conducteur, la laine d'acier.

3. Dispositif tel que revendiqué dans la revendication 1, dans lequel la partie d'engagement (22) comprend un ressort hélicoïdal (24) comprenant une pluralité de spires et ayant un axe central (YY) configuré pour être agencé transversalement à un développement longitudinal du composant.

4. Dispositif tel que revendiqué dans la revendication 1, dans lequel la partie d'engagement (22) comprend une pluralité de ressorts (25) se projetant depuis le corps rigide (20).

5. Dispositif tel que revendiqué dans la revendication 1, dans lequel la partie d'engagement (22), au moins lorsqu'elle est dans une configuration non déformée, fait saillie dudit siège (21).

6. Dispositif tel que revendiqué dans la revendication 1 ou 5, dans lequel le siège (21) est défini par un fraisage réalisé dans le corps rigide (20).

7. Dispositif tel que revendiqué dans l'une quelconque des revendications 1 à 6, dans lequel le corps rigide (20) est une barre.

8. Dispositif de contrôle de la conductivité électrique de pneus pour roues de véhicule, comprenant : un cadre support (16) pour un pneu (2) ; au moins une première électrode (17) configurée pour s'appuyer contre une surface d'un composant du pneu (2) ;
dans lequel ladite au moins une première électrode (17) est agencée radialement à l'extérieur du pneu (2) et est configurée pour s'appuyer contre une bande de roulement (9) du pneu (2) ; au moins une seconde électrode (18) configurée pour fermer un circuit électrique avec ledit composant dudit pneu (2) ;
dans lequel ladite au moins une seconde électrode (18) est agencée radialement à l'intérieur du pneu (2) et est configurée pour s'appuyer contre au moins un talon (7) du pneu (2) ;
au moins un compteur (19) connecté fonctionnellement à la première électrode (17) et à la seconde électrode (18), dans lequel le compteur (19) est configuré pour générer une tension entre la première électrode (17) et la seconde électrode (18) et obtenir une résistance électrique entre ladite première électrode (17) et ladite seconde électrode (18) ;
dans lequel la première électrode (17) comprend un corps rigide (20) et une partie d'engagement (22) plus souple que le composant, de manière à se déformer lorsque la première électrode (17) est placée contre la surface du composant et au moins partiellement copier au moins une concavité de ladite surface du composant ;
dans lequel la partie d'engagement (22) comprend un matériau élastiquement souple et électriquement conducteur ; **caractérisé en ce que** le matériau élastiquement souple et électriquement conducteur couvre extérieurement le corps rigide (20).

9. Dispositif tel que revendiqué dans la revendication 8, dans lequel le matériau souple et électriquement conducteur est choisi dans le groupe comprenant : le silicone électriquement conducteur, un matériau polymère expansé électriquement conducteur, la laine d'acier.

10. Dispositif tel que revendiqué dans l'une quelconque des revendications 8 et 9, dans lequel le corps rigide (20) est une barre.

11. Procédé de contrôle de la conductivité électrique de pneus pour roues de véhicule comprenant :
l'agencement d'un pneu (2) sur un cadre de support (16) ;
l'appui d'au moins une première électrode (17) contre une surface d'un composant du pneu (2) ;
dans lequel la première électrode (17) s'appuie contre une bande de roulement (9) du pneu (2) ;
l'appui d'au moins une seconde électrode (18) contre une partie différente du composant ou du pneu (2) ; dans lequel la seconde électrode (18) s'appuie contre au moins un talon (7) du pneu (2) ;
la génération d'une tension entre la première électrode (17) et la seconde électrode (18) et l'obtention d'une résistance électrique entre lesdites première électrode (17) et seconde électrode (18) ;
dans lequel l'appui de la première électrode (17) comprend l'appui d'une partie d'engagement (22) de la première électrode (17) contre la surface du composant,
dans lequel ladite partie d'engagement (22) est plus souple que le composant de manière à se déformer lorsque la première électrode (17) est en appui contre ladite surface du composant ;
la partie d'engagement déformée (22) définissant au moins une partie de contact électriquement conductrice (23) copiant au moins en partie au moins une concavité de ladite surface du composant ;
dans lequel la partie d'engagement (22) comprend un matériau élastiquement souple et électriquement conducteur ;
**caractérisé en ce que** le matériau élastiquement souple et électriquement conducteur couvre extérieurement un corps rigide (20) ou **en ce que** le corps rigide (20) a au moins un siège (21) et dans lequel la partie d'engagement (22) est au moins en partie logée dans ledit siège (21) ; dans lequel la partie d'engagement (22) est élastiquement souple et reprend sa propre forme non déformée lorsque la première électrode (17) est éloignée du composant.

12. Procédé tel que revendiqué dans la revendication 11, dans lequel ladite au moins une concavité comprend des dépressions d'une surface radialement externe de la bande de roulement.

13. Procédé tel que revendiqué dans la revendication 11, dans lequel, si le pneu est vulcanisé, ladite au moins une concavité comprend des rainures définissant une sculpture de la bande de roulement.
